# EUROPÄISCHE PATENTSCHRIFT

(11) **EP 2 027 759 B1**
(45) Veröffentlichungstag und Bekanntmachung des Hinweises auf die Patenterteilung: **06.01.2010**
(21) Anmeldenummer: 07725635.2
(22) Anmeldetag: 29.05.2007
(51) Int. Cl.: H05K 3/34, B23K 1/00

(54) **VORRICHTUNG ZUM LÖTEN IN DER DAMPFPHASE**
DEVICE FOR SOLDERING IN THE VAPOUR PHASE
DISPOSITIF POUR BRASER EN PHASE VAPEUR

(30) Priorität: 30.05.2006 DE 102006025184
(43) Veröffentlichungstag der Anmeldung: 25.02.2009
(73) Patentinhaber: IBL-Löttechnik GmbH, 86343 Königsbrunn (DE)
(72) Erfinder: LEICHT, Helmut, 91320 Ebermannstadt (DE)
(74) Vertreter: Vossius & Partner
(86) Internationale Anmeldenummer: PCT/EP2007/004744
(87) Internationale Veröffentlichungsnummer: WO 2007/137817

(56) Entgegenhaltungen:
- EP-A- 1 036 626
- WO-A-89/04234
- WO-A-03/106093
- DE-A1- 4 243 385
- DE-U1- 8 520 254
- FR-A1- 2 553 186
- US-A- 4 321 031

## Beschreibung

Die Erfindung betrifft eine Vorrichtung und ein Verfahren zum Löten von Lötgut, wie z.B. elektronischen Bauteilen auf Platinen. Insbesondere beziehen sich die erfindungsgemäße Vorrichtung und das Verfahren auf das Dampfphasenlöten.

Beim Löten werden zum Beispiel elektronische Bauteile mit einer Leiterplatte bzw. Platine elektrisch leitend verbunden. Eine bekannte Möglichkeit des Lötens ist das Reflow-Löten, bei dem ein Lot, z.B. in Form einer Paste, an entsprechenden Kontaktstellen der Platine durch bekannte Verfahren aufgebracht wird. Darauf werden die zu lötenden Bauteile entsprechend platziert. Anschließend wird das Lot durch Zuführung von Wärme, z.B. mittels Infrarotbestrahlung oder Dampf, in einen flüssigen Zustand gebracht und die elektronischen Bauteile beim folgenden Abkühlen mit der Platine verbunden. Die Bauteile können zusätzlich, z.B. mittels eines Klebers oder einer Fixiervorrichtung, an der Platine befestigt sein, um ein Verrutschen während des Lötvorgangs zu verhindern.

Das Dampfphasenlöten, auch VP-Löten oder Vapour Phase Reflow genannt, ist ein universelles, einfaches und zuverlässiges Lötverfahren und ist für jede Art von SMD-Komponenten und Trägermaterialien geeignet. Zur Wärmeübertragung von der Platinenumgebung auf die Platine wird bei diesem Verfahren vorzugsweise eine chemisch inerte Flüssigkeit (Liquid) eingesetzt. Der Siedepunkt der Flüssigkeit liegt typischerweise bei 200°C oder 215°C. Bei bleifreien Loten liegt die Siedetemperatur höher, etwa um 230°C. Siedet die Flüssigkeit, bildet sich über ihr ein Bereich bzw. eine Decke gesättigten Dampfes, die im Falle einer inerten Flüssigkeit keinen Sauerstoff oder andere Gase beinhaltet. So kann sich ohne die Verwendung von zusätzlichen Gasen, wie z.B. Stickstoff, eine reine Schutzgasatmosphäre bilden.

Taucht das Lötgut in die Dampfzone ein, kondensiert der Dampf auf dem Lötgut und überträgt seine Wärme auf das Lötgut, wobei die Temperatur des Lötguts maximal die Temperatur des Dampfes annehmen kann. Aufgrund dieser Eigenschaft ist der Dampfphasen-Lötprozess zuverlässig reproduzierbar und läuft ideal beherrschbar ab, weshalb unterschiedlichste Baugruppen, vom Flexprint bis zum mehrlagigen Multilayer, zuverlässig und ohne Überhitzung gelötet werden können.

Beim Dampfphasenlöten besteht jedoch das Problem, dass der Dampf beim Entfernen bzw. Einbringen des Lötguts aus der Dampfkammer entweichen kann.

Lötanlagen nach dem Stand der Technik verwenden meist eine sehr aufwändige und teure Schleusenkonstruktion. Dies macht es äußerst schwierig, kostengünstige kleine Maschinen zu bauen. Bei kleinen und kostengünstigen Maschinen wird auf eine gute Abschottung verzichtet und bewusst in Kauf genommen, dass beim Zuführen bzw. Entnehmen des Lotguts eine größere Menge Dampf entweicht. Der entweichende Dampf ist aber sehr teuer und erhöht die Betriebskosten einer solchen Anlage enorm, weshalb, auch hinsichtlich umweltpolitischer Gründe, eine Verbesserung wünschenswert ist. Der Aufwand ist letztendlich wegen des Dampfverbrauchs und den damit verbundenen Betriebskosten weit höher als die Kosten für eine teurere Anlage mit wenig Dampfverbrauch. Solche kostengünstigen Geräte können es auch kleinen Firmen ermöglichen, die nur gelegentlich Baugruppen löten, wettbewerbsfähig in bleifreier Löttechnik zu fertigen, vorausgesetzt die laufenden Kosten sind ebenfalls gering.

US-A-4 321 031 offenbart eine Lötvorrichtung gemäß dem oberbegriff des Anspruchs 1.

Der Erfindung liegt daher die Aufgabe zu Grunde, eine verbesserte Lötvorrichtung und ein verbessertes Verfahren bereitzustellen, die die oben genannten Nachteile überwinden und eine kostengünstige und effiziente Dampfphasenlötung ermöglichen. Diese Aufgabe wird durch eine Vorrichtung und ein Verfahren mit den Merkmalen der Patentansprüche gelöst.

Die Erfindung basiert auf dem Grundgedanken, eine Substratwechselöffnung der Lötanlage, die zum Zuführen bzw. Entnehmen von Lötgut aus der Lötvorrichtung geöffnet wird, und eine Lötkammeröffnung, durch die das Lötgut zum Löten in die Lötkammer bewegt wird, mit einer Verschlussvorrichtung zu öffnen bzw. zu schließen, die als eine Einheit ausgeführt ist. Die Verschlussvorrichtung ist dabei so ausgebildet, dass sie mit einer Bewegung die Substratwechselöffnung schließt und gleichzeitig die Lötkammeröffnung öffnet und umgekehrt, womit eine kostengünstige und effiziente Möglichkeit geschaffen wird, die den entweichenden Dampf auf ein ausreichend geringes Maß begrenzt.

Die Erfindung wird nachstehend mit Bezug auf die Zeichnungen näher erläutert; es zeigen:
- Figur 1: eine schematische, geschnittene Seitenansicht einer erfindungsgemäßen Vorrichtung mit geöffneter Substratwechselöffnung und geschlossener Lötkammeröffnung; und
- Figur 2: eine Seitenansicht ähnlich Figur 1 jedoch mit geschlossener Substratwechselöffnung und geöffneter Lötkammeröffnung.

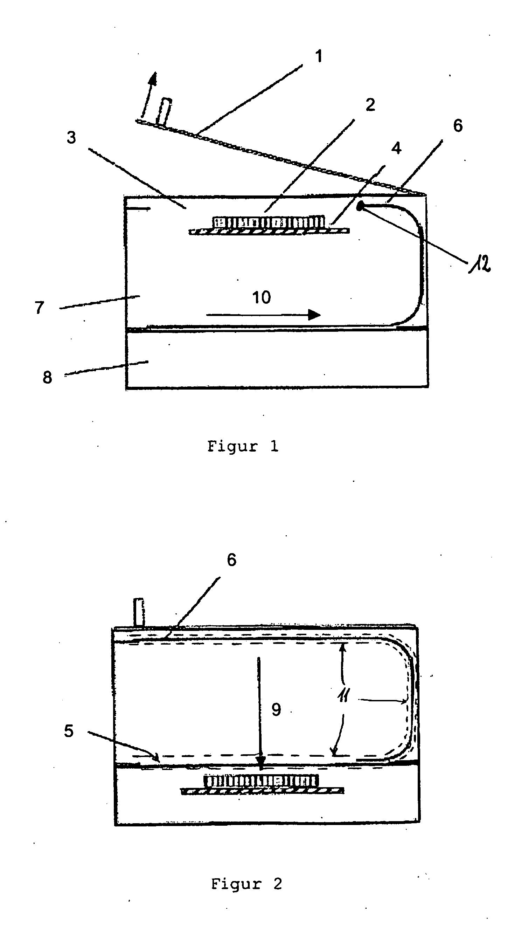

Figur 1 zeigt eine Lötvorrichtung, die eine Lötkammer 8 zur Aufnahme eines Liquids und eine daran angeordnete Zwischenkammer 7 aufweist, wobei die Kammern durch eine Lötkammeröffnung 5 verbunden sind. Die Zwischenkammer 7 weist zusätzlich zu der Lötkammeröffnung 5 eine Substratwechselöffnung 3 auf, auf der optional ein bewegbarer Deckel 1 angeordnet ist. Geöffnet und geschlossen werden die Lötkammeröffnung 5 und die Substratwechselöffnung 3 durch eine Verschlussvorrichtung 6, die gleichzeitig mit dem Öffnen der Substratwechselöffnung 3 die Lötkammeröffnung 5 schließt und umgekehrt. Ein Substrathalter 4 ist zwischen der Zwischenkammer 7 und der Lötkammer 8 durch die Lötkammeröffnung 5 bewegbar angeordnet. Zwei wesentliche Positionen des Substrathalters 4 sind die Substratwechselposition in der Zwischenkammer 7, in der Lötgut 2 zum Substrathalter 4 zugeführt bzw. entnommen werden kann, und die Lötposition in der Lötkammer 8, in der sich das Lötgut 2 in der Dampfzone zum Dampfphasenlöten befindet.

Die Lötkammer 8 weist vorzugsweise ein chemisch inertes Liquid auf, dessen Siedepunkt im Bereich von 150°C und 250°C, vorzugsweise im Bereich von 175°C und 225°C und besonders bevorzugt im Bereich von 200°C und 230°C liegt. Das bei Raumtemperatur flüssige Liquid wird mittels bekannten Verfahren auf die gewünschte Temperatur erhitzt. Das Liquid kann sofort nach Einschalten der Lötvorrichtung, vorzugsweise wahlweise aber auch erst zu einem bestimmten, manuell oder elektronisch gesteuertem Zeitpunkt zum Erzeugen einer Dampfzone erhitzt werden.

Die Verschlussvorrichtung 6, die aus einer Einheit besteht, weist im Wesentlichen mindestens ein flexibles Material auf. Zumindest die mit dem Dampf des Liquids in Kontakt stehenden Teile der Verschlussvorrichtung 6 stellen eine im Wesentlichen undurchlässige Barriere für den Dampf dar und halten zumindest der Siedetemperatur des verwendeten Liquids stand. Die Verschlussvorrichtung 6 kann auch aus mehreren Schichten aufgebaut sein, z.B. aus einem flexiblen Trägermaterial, wie z.B. ein Blech, das, falls nötig, entsprechend beschichtet wird. Das Trägermaterial kann beschichtet sein, z.B. mit einer Folie oder durch chemisches Behandeln. Die Verschlussvorrichtung 6 kann einen rollladenartigen Aufbau haben, d.h. aus mehreren Elementen bestehen, die eine Einheit bilden, und zumindest in den jeweiligen Endpositionen der Verschlussvorrichtung 6 für das Liquid eine undurchlässige Barriere darstellen. Während eines Positionswechsels der Verschlussvorrichtung 6, wie beim Öffnen bzw. Schließen der Öffnungen, kann ein solcher rollladenartiger Aufbau zur vorübergehenden Verbesserung der Flexibilität bzw. des Biegeradius der Verschlussvorrichtung 6 Dampfdurchlässig sein. Zur Führung der Verschlussvorrichtung 6 sind im Bereich der beiden zur Zeichenebene parallelen Kammerwände z.B. Schienen oder Nuten 11 vorgesehen, die lediglich in Figur 2 gestrichelt eingezeichnet sind.

Die Verschlussvorrichtung 6 wird vorzugsweise manuell und/oder elektrisch so betätigt, dass möglichst wenig dampfförmiges Liquid aus der Lötvorrichtung entweicht, d.h. die Verschlussvorrichtung wird möglichst schnell zwischen den Endpositionen hin- und herbewegt. Vorzugsweise wird die Verschlussvorrichtung 6 so betätigt, dass im Wesentlichen maximal das Volumen der mit Dampf gefüllten Zwischenkammer 7 aus der Lötvorrichtung entweicht.

Im Folgenden wird die Vorgehensweise bei der Verwendung der Lötvorrichtung gestützt auf die Figuren 1 und 2 näher dargelegt.

Ein Lötgut 2 wird auf dem Substratträger 4 in der Substratwechselposition in der Zwischenkammer 7 angeordnet.

Vorzugsweise wird das Lötgut 2 bzw. die darauf angeordneten Teile auf dem Substrathalter 4 fixiert. Anschließend wird die Verschlussvorrichtung 6 in Pfeilrichtung 10 verschoben bzw. das obere Ende der Verschlussvorrichtung 6 in Figur 1 von rechts nach links gezogen, z.B. mit Hilfe eines nur in Figur 1 eingezeichneten Griffs 12, wodurch die Substratwechselöffnung 3 geschlossen und gleichzeitig die Lötkammeröffnung 5 geöffnet wird. So entsteht ein durch die Zwischenkammer 7 und die Lötkammer 8 gebildeter gemeinsamer Innenraum. In der Zwischenkammer 7 kann das Lötgut optional auch durch den Dampf bzw. Restdampf und/oder zusätzlichen Einrichtungen, wie z.B. einer Infrarot-Vorheizung, vorgewärmt werden. Das Lötgut kann auch durch den Dampf aus der Lötkammer 8 vorgewärmt werden oder ohne Vorwärmung direkt mit dem Substratträger 4 in Pfeilrichtung 9 in die Lötkammer 8 transportiert werden. Der Substratträger 4 wird dabei durch bekannte Mittel manuell und/oder elektronisch gesteuert betätigt und bewegt.

So wird das Lötgut 2 in die in der Lötkammer 8 enthaltenen Dampfzone transportiert. Für bestimmte Anwendungen kann diese Einfahrt so gesteuert werden, dass ein sehr sanfter Temperaturanstieg realisiert wird. Der Dampf kondensiert auf dem Lötgut 2 ab und überträgt seine Wärme. Da der Dampf vorzugsweise chemisch inert ist und sich so kein Sauerstoff in dieser Zone befindet, ist eine Oxidation des Lötguts ausgeschlossen. Das Lötgut erwärmt sich maximal auf die Temperatur der Dampfzone, wobei diese Temperatur auch bei längeren Verweilzeiten nicht überschritten wird.

Nach der abgeschlossenen Lötphase wird das Lötgut 2 vom Substratträger 4 zurück in die Zwischenkammer 7 transportiert. Nach der Ausfahrt des Lötguts 2 aus dem Dampf verdampft das noch auf dem Lötgut befindliche Kondensat vorzugsweise rückstandsfrei durch die Eigenwärme des Lötguts 2. Optional kann das Lötgut 2 durch die kontrollierte Ausfahrt aus der Dampfzone und/oder durch zusätzliche Maßnahmen in der Zwischenkammer 7, wie z.B. Ventilatoren, kontrolliert abgekühlt werden.

Die Verschlussvorrichtung 6 wird anschließend so betätigt, dass die Substratwechselöffnung 3 geöffnet und gleichzeitig die Lötkammeröffnung 5 geschlossen wird, wonach das Lötgut 2 entnommen werden kann.

## Patentansprüche

1. Lötvorrichtung mit einer Lötkammer (8) zur Aufnahme eines Liquids mit einer Lötkammeröffnung (5), einer an der Lötkammeröffnung (5) angeordneten Zwischenkammer (7) mit einer Substratwechselöffnung (3) zum Zuführen bzw. Entnehmen von Lötgut (2) und mit einer Verschlussvorrichtung (6) zum Öffnen bzw. Schließen der Lötkammeröffnung (5) und der Substratwechselöffnung (3), **dadurch gekennzeichnet, dass** die Verschlussvorrichtung (6) als Einheit ausgeführt ist, so dass sie mit einer Bewegung beim Schließen der Substratwechselöffnung (3) gleichzeitig die Lötkammeröffnung (5) öffnet und umgekehrt.

2. Vorrichtung nach Anspruch 1, wobei das Liquid in der Lötkammer (8) chemisch inert ist.

3. Vorrichtung nach Anspruch 1 oder 2; wobei der Siedepunkt des Liquids zwischen 150°C und 250°C liegt.

4. Vorrichtung nach einem der vorhergehenden Ansprüche, wobei die Verschlussvorrichtung (6) aus einem Material besteht, das für das Liquid im Wesentlichen undurchlässig ist..

5. Vorrichtung nach einem der vorhergehenden Ansprüche, wobei das Material der Verschlussvorrichtung (6) zumindest einer der Siedetemperatur des Liquids entsprechenden Temperatur standhält.

6. Vorrichtung nach einem der vorhergehenden Ansprüche, wobei die Verschlussvorrichtung (6) aus einer Folie und/oder aus einem Blech besteht.

7. Vorrichtung nach einem der vorhergehenden Ansprüche, wobei die Verschlussvorrichtung (6) einen rollladenartigen Aufbau hat.

8. Vorrichtung nach einem der vorhergehenden Ansprüche, wobei ein Substratträger (4) zwischen einer Substratwechselposition in der Zwischenkammer (7) und einer Lötposition in der Lötkammer (8) mechanisch und/oder elektrisch bewegbar angeordnet ist.

9. Vorrichtung nach Anspruch 8, wobei der Substratträger (4) bei geschlossener Substratwechselöffnung (3) von der Substratwechselposition in die Lötposition bewegbar ist.

10. Verfahren zum Dampfphasenlöten von Lötgut mit den Schritten:
- Öffnen einer Substratwechselöffnung (3) und gleichzeitiges Schließen einer Lötkammeröffnung (5) durch eine Verschlussvorrichtung (6) mit einer Bewegung;
- Anordnen des Lötguts (2) auf einem Substratträger (4) in einer Substratwechselposition in einer Zwischenkammer (7);
- Schließen der Substratwechselöffnung (3) und gleichzeitiges Öffnen der Lötkammeröffnung (5) durch die Verschlussvorrichtung (6) mit einer Bewegung;
- Bewegen des Substratträgers (4) mit dem darauf angeordneten Lötgut (2) von der Substratwechselposition in eine Lötposition in der Lötkammer (8);
- Dampfphasenlöten des Lötguts (2) in der Lötkammer (8);
- Bewegen des Substratträgers (4) mit dem darauf angeordneten Lötgut (2) von der Lötposition in die Substratwechselposition;
- Öffnen der Substratwechselöffnung (3) und gleichzeitiges Schließen der Lötkammeröffnung (5);
- Entnehmen des Lötguts (2).

## Claims

1. A soldering device comprising a soldering chamber (8) for receiving a liquid and comprising a soldering chamber opening (5), an intermediate chamber (7) arranged at the soldering chamber opening (5) and having a substrate changing opening (3) for supplying and removing items (2) to be soldered, and a closure device (6) for opening and closing the soldering chamber opening (5) and the substrate changing opening (3), **characterized in that** the closure device (6) is designed as a unit such that when the substrate changing opening (3) is being closed it opens in one movement at the same time the soldering chamber opening (5) and vice versa.

2. The device according to claim 1, wherein the liquid in the soldering chamber (8) is chemically inert.

3. The device according to claim 1 or 2, wherein the boiling point of the liquid is between 150°C and 250°C.

4. The device according to any one of the preceding claims, wherein the closure device (6) is made of a material which is essentially non-permeable to the liquid.

5. The device according to any one of the preceding claims, wherein the material of the closure device (6) withstands at least a temperature corresponding to the boiling temperature of the liquid.

6. The device according to any one of the preceding claims, wherein the closure means (6) is made of a foil or film and/or of a metal sheet.

7. The device according to any one of the preceding claims, wherein the structure of the closure device (6) is like that of a roller shutter.

8. The device according to any one of the preceding claims, wherein a substrate support (4) is arranged between a substrate changing position in the intermediate chamber (7) and a soldering position in the soldering chamber (8) in a manner so as to be mechanically and/or electrically movable.

9. The device according to claim 8, wherein the substrate support (4) can be moved from the substrate changing position into the soldering position when the substrate changing opening (3) is closed.

10. A method for vapor phase soldering items to be soldered, the method comprising the steps of:
- opening a substrate changing opening (3) and at the same time closing a soldering chamber opening (5) by a closure device (6) in one movement;
- arranging the item (2) to be soldered on a substrate support (4) in a substrate changing position in an intermediate chamber (7);
- closing the substrate changing opening (3) and at the same time opening the soldering chamber opening (5) by the closure device (6) in one movement;
- moving the substrate support (4) with the item (2) to be soldered arranged thereon from the substrate changing position to a soldering position in the soldering chamber (8);
- vapor phase soldering the item (2) to be soldered in the soldering chamber (8);
- moving the substrate support (4) with the item (2) to be soldered arranged thereon from the soldering position to the substrate changing position;
- opening the substrate changing opening (3) and at the same time closing the soldering chamber opening (5);
- removing the item (2) to be soldered.

## Revendications

1. Dispositif de brasage avec une chambre de brasage (8) pour recevoir un liquide et comprenant une ouverture de chambre de brasage (5), une chambre intermédiaire (7) aménagée à l'ouverture de la chambre de brasage (5) avec une ouverture de changement de substrat (3) pour alimenter et retirer des articles à être brasés (2) et avec un dispositif de fermeture (6) pour ouvrir et fermer l'ouverture de la chambre de brasage (5) et l'ouverture de changement de substrat (3), **caractérisé en ce que** le dispositif de fermeture (6) est dessiné comme une unité, afin qu'elle ouvre avec un mouvement lors de la fermeture de l'ouverture de changement de substrat (3) en même temps l'ouverture de la chambre de brasage (5) et vice versa.

2. Dispositif selon la revendication 1, dans lequel le liquide dans la chambre des brasage (8) est chimiquement inerte.

3. Dispositif selon la revendication 1 ou 2, dans lequel le point d'ébullition du liquide est situé entre 150°C et 250°C.

4. Dispositif selon l'une quelconque des revendication précédentes, dans lequel le dispositif de fermeture (6) consiste en un matériau qui est essentiellement imperméable pour le liquide.

5. Dispositif selon l'une quelconque des revendications précédentes, dans lequel le matériau du dispositif de fermeture (6) résiste à au moins une température correspondant à la température d'ébullition du liquide.

6. Dispositif selon l'une quelconque des revendications précédentes, dans lequel le dispositif de fermeture (6) consiste en un film et/ou une tôle.

7. Dispositif selon l'une quelconque des revendications précédentes, dans lequel le dispositif de fermeture (6) est construit comme un volet roulant.

8. Dispositif selon l'une quelconque des revendications précédentes, dans lequel un support de substrat (4) est aménagé de manière à être agité mécaniquement et/ou électriquement entre une position de changement de substrat dans la chambre intermédiaire (7) et une position de brasage dans la chambre de brasage (8).

9. Dispositif selon la revendication 8, dans lequel le support de substrat (4) peut être agité de la position de changement de substrat à la position de brasage lorsque l'ouverture de changement de substrat (3) est fermée.

10. Procédé de brasage in phase vapeur d'articles à être brasés comprenant les étapes :
- ouvrir une ouverture de changement de substrat (3) et en même temps fermer une ouverture de chambre de brasage (5) par un dispositif de fermeture (6) avec un mouvement ;
- aménager les articles à être brasés (2) sur un support de substrat (4) dans une position de changement des substrat dans une chambre intermédiaire (7) ;
- fermer l'ouverture de changement de substrat (3) et en même temps ouvrir l'ouverture de la chambre de brasage (5) par le dispositif de fermeture (6) avec un mouvement ;
- agiter le support de substrat (4) avec les articles à être brasés (2) disposés sur celui-ci de la position de changement de substrat à une position de brasage dans la chambre de brasage (8) ;
- braser en phase vapeur les articles à être brasés (2) dans la chambre des brasage (8) ;
- agiter le support de substrat (4) avec les articles à être brasés (2) disposés sur celui-ci de la position de brasage à la position de changement de substrat ;
- ouvrir l'ouverture de changement de substrat (3) et en même temps fermer l'ouverture de la chambre de brasage (5) ;
- enlever les articles à être brasés (2).
